# EUROPEAN PATENT APPLICATION

(11) **EP 4 768 955 A1**
(43) Date of publication of application: **01.07.2026**
(21) Application number: 24888955.2
(22) Date of filing: 14.10.2024
(51) Int. Cl.: G01R 31/392, G01R 31/389, G01R 31/396, G01R 23/00

(54) **SOH PREDICTION DEVICE AND OPERATING METHOD THEREOF**

(30) Priority: 09.11.2023 KR 20230154429
(71) Applicant: LG Energy Solution, Ltd., Seoul 07335 (KR)
(72) Inventor: KIM, Hyeon Su, Daejeon 34122 (KR); KIM, Young Hwan, Daejeon 34122 (KR)
(74) Representative: Plasseraud IP
(86) International application number: PCT/KR2024/015511
(87) International publication number: WO 2025/100761

(57) **Abstract**

A state of health (SOH) prediction device according to one embodiment disclosed herein may include a battery pack, an electrochemical impedance spectroscopy (EIS) data acquisition unit configured to acquire EIS data of the battery pack, a feature point identification unit configured to identify a plurality of feature points based on the EIS data, a resistance parameter calculation unit configured to calculate a resistance parameter related to impedance of the battery pack based on impedance related to the plurality of feature points, and an SOH prediction unit configured to predict an SOH of the battery pack corresponding to the resistance parameter based on the resistance parameter corresponding to each of the plurality of temperatures and a first function representing tendency between the resistance parameter and the SOH of the battery pack.

## Description

### Technical Field

### CROSS-REFERENCE TO RELATED APPLICATION

This application claims priority to and the benefit of Korean Patent Application No. 10-2023-0154429 filed in the Korean Intellectual Property Office on November 9, 2023, the entire contents of which are incorporated herein by reference.

### TECHNICAL FIELD

Embodiments disclosed herein relate to a state of health (SOH) prediction device and a method of operating the same.

### Background Art

Recently, research and development on secondary batteries has been actively conducted. Here, the secondary battery is a battery capable of charging and discharging and includes all of conventional Ni/Cd batteries, Ni/MH batteries, etc. and recent lithium ion batteries. Among the secondary batteries, lithium-ion batteries have an advantage of having much higher energy density than conventional Ni/Cd batteries and Ni/MH batteries. In addition, the lithium-ion batteries may be made smaller and lighter and thus are used as a power source for mobile devices and recently, are attracting attention as next-generation energy storage media due to the expansion of the range of usage to a power source for electric vehicles.

A battery exchange system is present as a service related to these secondary batteries. The battery exchange system may provide users with a service that exchanges a discharged battery with a charged battery.

Such a battery exchange system may use a method of measuring a lifetime of a battery used for service. For example, an electrochemical impedance spectroscopy (EIS) may be used as a method for measuring the lifetime of a battery.

### Disclosure

### Technical Problem

One embodiment disclosed herein is directed to providing a state of health (SOH) prediction device for predicting a SOH of a battery pack based on a resistance parameter related to impedance of the battery pack, and a method of operating the same.

The objects of the embodiments disclosed herein are not limited to the above-described objects, and other objects that are not described will be able to be clearly understood by those skilled in the art from the following description.

### Technical Solution

A state of health (SOH) prediction device according to one embodiment disclosed herein may include a battery pack, an electrochemical impedance spectroscopy (EIS) data acquisition unit configured to acquire EIS data of the battery pack, a feature point identification unit configured to identify a plurality of feature points based on the EIS data, a resistance parameter calculation unit configured to calculate a resistance parameter related to impedance of the battery pack based on impedance related to the plurality of feature points, and an SOH prediction unit configured to predict an SOH of the battery pack corresponding to the resistance parameter based on the resistance parameter corresponding to each of the plurality of temperatures and a first function representing tendency between the resistance parameter and the SOH of the battery pack.

According to one embodiment, the EIS data may include data on an EIS graph shown by dividing the impedance of the battery pack into a real part and an imaginary part, and a first feature point among the plurality of feature points may be determined based on a size of the real part of the impedance among the plurality of points identified based on the EIS graph.

According to one embodiment, the first feature point may be related to a point at which a real part value of the impedance is the smallest among the plurality of points identified based on the EIS graph, or a point located within a preset range from the point at which the real part value is the smallest.

According to one embodiment, the second feature point among the plurality of feature points may be related to a maximum point of the EIS graph among the plurality of points identified based on the EIS graph, or a point located within a preset range from the maximum point.

According to one embodiment, the maximum point may be related to a point at which an absolute value is the greatest among points at which an imaginary part impedance value is negative among points having a higher frequency than points at which Warburg impedance is present among the plurality of points identified based on the EIS graph, or a point located within a preset range from the point at which the absolute value is the greatest among the points at which the value of the imaginary part impedance is negative.

According to one embodiment, the resistance parameter calculation unit may calculate the resistance parameter based on a difference between the real part value of the impedance related to the second feature point and the real part value of the impedance related to the first feature point.

According to one embodiment, the first function may be generated based on a plurality of SOHs included in a reference SOH in a preset SOC condition and a preset temperature condition of the reference battery pack in the idle state, and a resistance parameter corresponding to each of the plurality of SOHs.

According to one embodiment, the first function may include at least one of an n^{th} order (n is a natural number) polynomial function, an exponential function, and a logarithmic function.

A method of operating a state of health (SOH) prediction device according to one embodiment disclosed herein may include acquiring electrochemical impedance spectroscopy (EIS) data of a battery pack, identifying a plurality of feature points based on the EIS data, calculating a resistance parameter related to impedance of the battery pack based on impedance related to the plurality of feature points, and predicting an SOH of the battery pack corresponding to the calculated resistance parameter based on the resistance parameter corresponding to each of the plurality of temperatures and a first function representing tendency between the resistance parameter and the SOH of the battery pack.

According to one embodiment, the EIS data may include data on an EIS graph shown by dividing the impedance of the battery pack into a real part and an imaginary part, and a first feature point among the plurality of feature points may be determined based on a size of the real part of the impedance among the plurality of points identified based on the EIS graph.

According to one embodiment, the first feature point may be related to a point at which a real part value of the impedance is the smallest among the plurality of points identified based on the EIS graph, or a point located within a preset range from the point at which the real part value is the smallest, and the second feature point may be related to a maximum point of the EIS graph among the plurality of points identified based on the EIS graph.

According to one embodiment, the first function may be generated based on a plurality of SOHs included in a reference SOH in a preset SOC condition and a preset temperature condition of the reference battery pack in the idle state, and a resistance parameter corresponding to each of the plurality of SOHs.

According to one embodiment, the first function may include at least one of an n^{th} order (n is a natural number) polynomial function, an exponential function, and a logarithmic function.

### Advantageous Effects

The SOH prediction device according to one embodiment disclosed herein can predict the SOH according to the resistance parameter without collecting the resistance parameter corresponding to each of all SOHs.

The SOH prediction device according to one embodiment disclosed herein can approximate the resistance parameter to acquire the approximated resistance parameter through the pattern and coordinates of the EIS data.

The effects according to one embodiment disclosed herein are not limited to the above-described effects and other effects that are not described will be able to be clearly understood by those skilled in the art according to the disclosure of the present document.

### Description of Drawings

FIG. 1 is a view for describing a state of health (SOH) prediction device according to one embodiment disclosed herein.
FIG. 2 is a view for describing electrochemical impedance spectroscope (EIS) data according to one embodiment disclosed herein.
FIG. 3 is a graph for describing the tendency between a resistance parameter and an SOH according to one embodiment disclosed herein.
FIG. 4 is a view for describing relationship data generated according to one embodiment disclosed herein.
FIG. 5 is a flowchart for describing an operation of the SOH prediction device according to one embodiment disclosed herein.

### Mode for Invention

Hereinafter, embodiments disclosed herein will be described in detail with reference to exemplary drawings. In adding reference numerals to components in each drawing, it should be noted that the same components have the same reference numerals as much as possible even when they are shown in different drawings. In addition, in describing embodiments disclosed herein, the detailed description of related known configurations or functions will be omitted when it is determined that the detailed description obscures the understanding of the embodiments disclosed herein.

The terms, such as first, second, A, B, (a), and (b) may be used to describe components of the embodiments disclosed in this document. These terms are only for the purpose of distinguishing one component from another component, and the nature, sequence, order, or the like of the corresponding component is not limited by the terms. In addition, unless otherwise defined, all terms (including technical and scientific terms) used herein have the same meanings as those commonly understood by those skilled in the art to which embodiments disclosed herein pertains. The terms defined in a generally used dictionary should be construed as meanings that match with the meanings of the terms from the context of the related technology and are not construed as an ideal or excessively formal meaning unless clearly defined in this application.

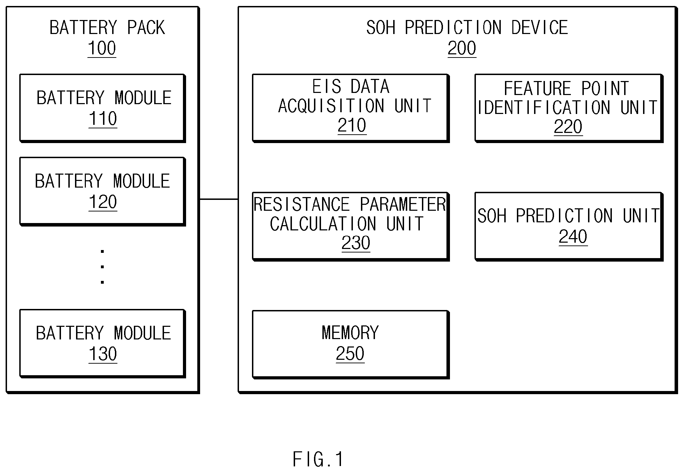

FIG. 1 is a view for describing a state of health (SOH) prediction device according to one embodiment disclosed herein.

A battery pack 100 may include a plurality of battery modules 110, 120, and 130. Referring to FIG. 1, it is shown that the battery pack 100 includes three battery modules 110, 120, and 130, but is not limited thereto, and the battery pack 100 may include n (n is a natural number) battery modules. Each of the plurality of battery modules 110, 120, and 130 may include a plurality of battery cells (not shown). The plurality of battery cells (not shown) may be lithium ion (Li-ion) batteries, nickel hydrogen (Ni-H) batteries, etc., but are not limited thereto.

The battery pack 100 may be configured to supply power to a target device (not shown), and to this end, the battery pack 100 may be electrically connected to the target device (not shown). Here, the target device (not shown) may include an electrical, electronic, or mechanical device operated by receiving power from the battery pack 100, and for example, the target device (not shown) may be a two-wheeled electric vehicle such as an electric vehicle (EV) or an electric scooter, but is not limited thereto. In addition, when the target device is a two-wheeled electric vehicle such as an electric scooter, the battery pack 100 mounted on the two-wheeled electric vehicle may be replaced through a battery swapping station (BSS).

A SOH prediction device 200 may predict a SOH of the battery pack 100 based on a resistance parameter of the battery pack 100. Referring to FIG. 1, the SOH prediction device 200 may include an EIS data acquisition unit 210, a feature point identification unit 220, a resistance parameter calculation unit 230, an SOH prediction unit 240, and a memory 250.

The EIS data acquisition unit 210 may acquire EIS data acquired as a result of the EIS measurement of the battery pack 100. According to an embodiment, the EIS measurement may include an operation of measuring the impedance of the battery pack 100 by applying an AC voltage to the battery pack 100.

According to an embodiment, the EIS data may include data on an EIS graph. For example, the EIS graph may be a Nyquist plot shown by dividing the impedance of the battery pack 100 measured by changing a frequency of the AC voltage into a real part and an imaginary part.

According to one embodiment, the EIS data acquisition unit 210 may acquire EIS data by directly applying a voltage and/or current to the battery pack 100. In this case, the EIS data acquisition unit 210 may include various circuits for applying a voltage and/or current to the battery pack 100 and a processor for processing the acquired EIS data.

According to one embodiment, the EIS data acquisition unit 210 may indirectly acquire the EIS data from the battery pack 100. In this case, the EIS data acquisition unit 210 may include a communication module for communicating with the battery pack 100 in a wired and/or wireless manner.

The feature point identification unit 220 may identify a plurality of feature points based on the acquired EIS data. According to one embodiment, the feature point identification unit 220 may identify at least two feature points among the plurality of feature points identified based on the EIS graph included in the EIS data.

According to an embodiment, a first feature point among the plurality of feature points may correspond to a point at which a real part value of the impedance of the battery pack 100 is the smallest and a point at which an imaginary part value of the impedance of the battery pack 100 is zero, or correspond to a point at which the real part value of the impedance is the smallest or one of points located within a preset range from the point at which the imaginary part value of the impedance is zero.

According to an embodiment, a second feature point among the plurality of feature points may correspond to a maximum point in the EIS graph or one of points located within the preset range from the maximum point. Here, the maximum point may correspond to a point at which an imaginary part impedance value is the smallest among points having a higher frequency than points at which Warburg impedance is present among a plurality of points identified based on the EIS graph.

The resistance parameter calculation unit 230 may calculate a resistance parameter related to the impedance of the first feature point and the second feature point among the plurality of feature points. According to an embodiment, the resistance parameter may be determined based on a difference between the real part value of the impedance corresponding to the second feature point and the real part value of the impedance corresponding to the first feature point.

The SOH prediction unit 240 may predict the SOH of the battery pack 100 based on a temperature at which the EIS data are acquired and a resistance parameter calculated based on the EIS data. According to an embodiment, the SOH prediction unit 240 may predict the SOH of the battery pack 100 based on a first function representing the tendency between the resistance parameter and the SOH of the battery pack 100.

The memory 250 may store data related to the first function. In addition, the memory 250 may store relationship data (not shown) indicating the relationship between the temperature, the resistance parameter, and the SOH of the battery pack 100 based on the first function. According to an embodiment, the memory 260 may include a volatile memory device such as a static random access memory (SRAM) or a dynamic random access memory (DRAM), or a non-volatile memory device such as a read only memory (ROM), a programmable ROM (PROM), or a flash memory.

Referring to FIG. 1, it is shown that the memory 250 is included in the SOH prediction device 200, but is not limited thereto, and the memory 250 may be located outside the SOH prediction device 200.

According to an embodiment, the feature point identification unit 220, the resistance parameter calculation unit 230, and the SOH prediction unit 240 may be implemented as one processor or a separate processor. Here, the processor may execute software to control one or more other components (e.g., hardware or software) of the SOH prediction device 200 or perform operations of processing and/or calculating various pieces of data.

According to an embodiment, the SOH prediction device 200 may be formed integrally with the battery pack 100. In this case, the SOH prediction device 200 may be included in a battery management system (BMS) of the battery pack 100.

According to an embodiment, the SOH prediction device 200 may be formed separately from the battery pack 100. In this case, the SOH prediction device 200 may be connected to the battery pack 100 via a wired and/or wireless network. In this case, the SOH prediction device 200 may be implemented through a cloud server.

According to an embodiment, the SOH prediction device 200 may transmit the relationship data and/or the SOH of the battery pack 100 predicted by the SOH prediction unit 240 to an external device (e.g., a cloud server or a user terminal). The cloud server may be configured to provide the predicted SOH of the battery pack 100 to each of a plurality of users, and the user terminal may include a terminal such as a personal computer (PC) or a smartphone.

According to an embodiment, the SOH prediction device 200 may be included in a BSS. The BSS may be a system that may have a slot into which the battery pack 100 may be inserted and charge the inserted battery pack 100.

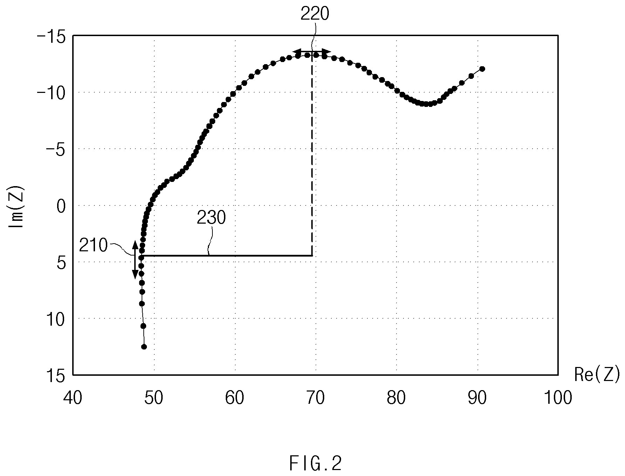

FIG. 2 is a view for describing electrochemical impedance spectroscope (EIS) data according to one embodiment disclosed herein.

Referring to FIG. 2, an EIS graph included in the EIS data is schematically shown.

As described above in the detailed description of FIG. 1, the EIS data may include data on the EIS graph shown by dividing the impedance of the battery pack 100, which is measured by changing the frequency of the AC power applied to the battery pack 100 (see FIG. 1), into a real part Re(Z) and an imaginary part Im(Z). According to an embodiment, a horizontal axis of the EIS graph may be a coordinate axis corresponding to the real part Re(Z), and a vertical axis may be a coordinate axis corresponding to the imaginary part Im(Z).

The feature point identification unit 220 (see FIG. 1) may identify the first feature point 210 and the second feature point 220 among the plurality of feature points identified based on the EIS graph. According to an embodiment, the first feature point 210 may correspond to a point at which the real part value of the impedance of the battery pack 100 has the smallest impedance and a point at which the imaginary part value of the impedance of the battery pack 100 is zero, or correspond to the point at which the real value of the impedance is the smallest or one of points located within a preset range from the point at which the imaginary value of the impedance is zero. In addition, the second feature point 220 may correspond to the maximum point in the EIS graph or one of the points located within the preset range from the maximum point. Here, the maximum point may correspond to a point at which an imaginary part impedance value is the smallest among points having a higher frequency than points at which Warburg impedance is present among the plurality of points identified based on the EIS graph. That is, the second feature point 220 may correspond to a point at which an absolute value is the greatest among points at which the value of the imaginary part impedance is negative among the points having a higher frequency than the points at which Warburg impedance is present, or a point located within the preset range from the point at which the absolute value is the greatest among the points at which the impedance value is negative.

According to an embodiment, the preset range may be set and changed in various ways according to an allowable error range of EIS analysis. Hereinafter, for convenience of description, description will be made assuming that the first feature point 210 is the point at which the real part value of the impedance of the battery pack 100 is the smallest and the second feature point 220 is the maximum point, but the present document is not limited to such an embodiment.

The resistance parameter calculation unit 230 (see FIG. 1) may calculate a resistance parameter 230 based on the first feature point 210 and the second feature point 220. According to an embodiment, the resistance parameter 230 may be determined based on a difference between a real part resistance value of the second feature point 220 and a real part resistance value of the first feature point 210.

According to an embodiment, a difference between the real part resistance value of the impedance of the second feature point 220 and the real part resistance value of the impedance of the first feature point 210 may be approximated to a real number multiple, for example, k*Rct (here, k is a real number) of a charger transfer resistance Rct generated by an electrode reaction of the battery pack 100 (see FIG. 1). For example, the resistance parameter calculation unit 230 may compare the charge transfer resistance Rct of the battery pack 100 acquired based on the EIS data with the resistance parameter and determine a k value.

According to an embodiment, the value of k may include 0.5. In this case, the resistance parameter calculated by the resistance parameter calculation unit 230 may be approximated to (0.5*Rct) corresponding to half of the charge transfer resistance Rct of the battery pack 100. However, this is exemplary, and the value of k may be set in various ways according to the characteristics of the battery pack 100.

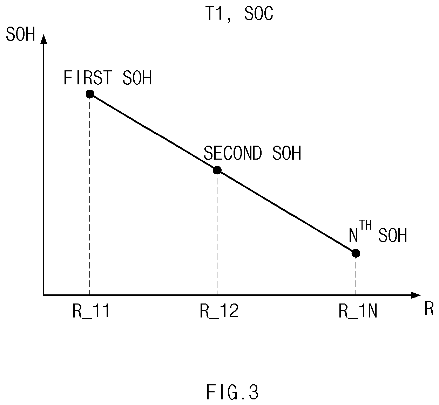

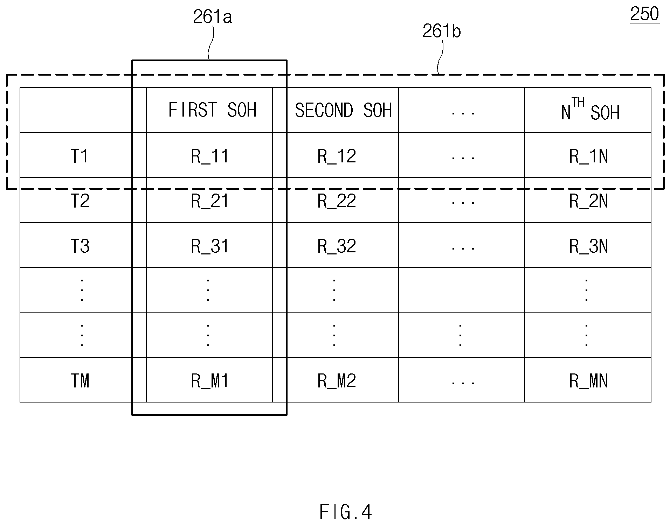

FIG. 3 is a graph for describing the tendency between a resistance parameter and an SOH according to one embodiment disclosed herein, and FIG. 4 is a view for describing relationship data generated according to one embodiment disclosed herein.

FIG. 3 shows a graph showing the tendency between the resistance parameter and the SOH in which a horizontal axis corresponds to a resistance parameter R and a vertical axis corresponds to an SOH of the reference battery pack. Here, the reference battery pack may be the same type of battery pack as the battery pack 100 shown in FIG. 1.

There may be the tendency between a temperature T at which the EIS data of the reference battery pack entering an idle section is acquired and the resistance parameter R of the reference battery pack.

There may be the tendency between the resistance parameter R of the reference battery pack entering the idle section and the SOH of the reference battery pack.

According to an embodiment, the first function may be a function representing the tendency between the resistance parameter R of the reference battery pack and the SOH of the reference battery pack. For example, the first function may be a function that may be generated based on SOHs first SOH to N^{th} SOH of the reference battery pack corresponding to resistance parameters R11 to R1N shown in FIGS. 3 and 4 in the reference battery pack under a preset temperature condition T1 and a preset state of charge (SOC) condition.

According to an embodiment, the first function may include an n^{th} order (n is a natural number) polynomial function. For example, when n is 1, the tendency between the resistance parameters R11 to R1N of the reference battery pack and the SOH of the reference battery pack may be represented in the form of a linear function (ax+b, a and b are real numbers). Here, a coefficient of the linear function and a coefficient of the constant term may be set and changed in various ways. In addition, the embodiments disclosed herein is not limited to the linear function, and for example, the first function may be a function that may represent the tendency between the resistance parameter of the reference battery pack and the SOH of the reference battery pack, such as a logarithmic function, an exponential function (here, the exponent is an integer, an irrational number, or a rational number).

According to an embodiment, when the first function is an n^{th} polynomial function, data between at least (n+1) resistance parameters of the reference battery pack and the SOH of the reference battery pack may be required to derive the first function. For example, when the first function is represented in the form of the linear function, data between at least two resistance parameters and an SOH may be required. However, this is a minimum criterion for deriving the first function, and the more data is present to derive the first function, the higher the accuracy of the first function may be. When the first function is represented by an n^{th} polynomial function, the SOH prediction unit 240 may derive the first function based on at least (n+1) data and use data between more resistance parameters and the SOH to derive a sophisticated first function.

According to an embodiment, the first function may vary depending on a predetermined temperature condition and a predetermined SOC condition.

According to an embodiment, the number of data between the resistance parameter of the reference battery pack and the SOH of the reference battery pack that are required to derive the first function, may be applied by being changed in various ways according to designs.

Referring to FIG. 4, relationship data that may be generated based on the above-described first function is shown. The relationship data may be stored in the memory 250 in the form of a look-up table.

The relationship data may include data indicating the relationship between a temperature at which the EIS data of the reference battery pack is acquired, an SOH of the reference battery pack, and a resistance parameter of the reference battery pack. According to an embodiment, the relationship data may include data 261b on resistance parameters R_11 to R_MN at the specific temperature T1 and SOHs first SOH to N^{th} SOH of the reference battery pack corresponding to the resistance parameters R_11 to R_MN, and data 261a on resistance parameters R_11 to R_M1 at the specific SOH (first SOH) and temperatures T1 to TM corresponding to the resistance parameters R_11 to R_M1. Relationship data between M temperatures T1 to T5 and N SOHs first SOH to N^{th} SOH is shown in FIG. 4, which is exemplary.

According to an embodiment, the relationship data may include the plurality of temperatures T1 to TM and resistance parameters corresponding to the SOH of the reference battery pack at each of the plurality of temperatures. For example, the relationship data may include data on resistance parameters R_11 to R_1N corresponding to the plurality of SOHs first SOH to N^{th} SOH, respectively, at a first temperature T1. Here, the number of plurality of temperatures T1 to TM is shown to be M, but the plurality of temperatures, the number of resistance parameters at each of the plurality of temperatures, and/or an interval between the temperatures, which are included in the relationship data, may be applied by being changed in various ways depending on designs. For example, the relationship data may include data on the M temperatures at a temperature in the range of 10 °C to 45 °C, and resistance parameters corresponding to a plurality of SOHs at the M temperatures, and data on a plurality of temperatures in the range of various temperatures rather than the range of 10 °C to 45 °C, and resistance parameters corresponding to a plurality of SOHs at the plurality of temperatures, and for example, an interval between the M temperatures may be set in various ways, such as 1 °C, 0.5 °C, or 2 °C.

According to an embodiment, the SOH prediction unit 240 (see FIG. 1) may supplement the relationship data based on the first function described above in FIG. 3. For example, the SOH prediction unit 240 may acquire an SOH corresponding to the resistance parameter (not shown in FIG. 4) acquired based on the first function.

To predict the lifetime of the battery pack through EIS analysis, EIS data needs to be repeatedly collected by changing various conditions (e.g., a temperature, a SOC, and a SOH). However, the process of repeatedly collecting the EIS data as described above may be time-consuming.

The SOH prediction device according to one embodiment disclosed herein may predict the SOH of the battery pack based on the function acquired by changing conditions in which a tendency is present without having to collect EIS data under any condition (e.g., all SOHs). In addition, since the SOH prediction device according to one embodiment disclosed herein may approximate the resistance parameter calculated based on the impedance between the first and second feature points to real number times the charge transfer resistance, the SOH of the battery pack may be predicted without measuring the charge transfer resistance of the battery pack.

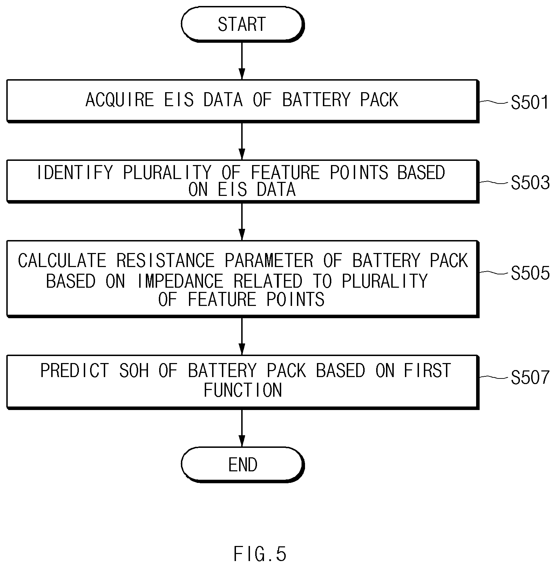

FIG. 5 is a flowchart for describing an operation of the SOH prediction device according to one embodiment disclosed herein.

In operation S501, the SOH prediction device 200 (see FIG. 1) may acquire the EIS data of the battery pack 100 (see FIG. 1). According to an embodiment, the EIS data may include data on an EIS graph shown by dividing the impedance of the battery pack 100 into a real part and an imaginary part.

In operation S503, the SOH prediction device 200 may identify a plurality of feature points based on the EIS data. According to an embodiment, a first feature point among the plurality of feature points may correspond to a point at which a real part value of the impedance of the battery pack 100 is the smallest and a point at which an imaginary part value of the impedance of the battery pack 100 is zero, or correspond to a point at which the real part value of the impedance is the smallest or one of points located within a preset range from the point at which the imaginary part value of the impedance is zero in the EIS graph. In addition, according to an embodiment, a second feature point among the plurality of feature points may correspond to a maximum point in the EIS graph or one of points located within the preset range from the maximum point. Here, the maximum point may correspond to a point at which an imaginary impedance value is the smallest among points having a higher frequency than points at which Warburg impedance is present among a plurality of points identified based on the EIS graph. That is, the second feature point 220 may correspond to a point at which an absolute value is the greatest among points at which the value of the imaginary part impedance is negative among the points having a higher frequency than the points at which Warburg impedance is present.

In operation S505, the SOH prediction device 200 may calculate a resistance parameter of the battery pack 100 based on the impedance related to the plurality of feature points. According to an embodiment, the resistance parameter may be determined based on a difference between the real part value of the impedance corresponding to the second feature point and the real part value of the impedance corresponding to the first feature point.

In operation S507, the SOH prediction device 200 may calculate an SOH of the battery pack 100 based on the first function.

According to an embodiment, the first function may be generated based on a plurality of SOHs included in a reference SOH in a preset SOC condition and a preset temperature condition of the reference battery pack in the idle state, and a resistance parameter corresponding to each of the plurality of SOHs.

According to an embodiment, the first function may be a function representing the tendency between the resistance parameter R of the reference battery pack and the SOH of the reference battery pack.

According to an embodiment, the first function may include an n^{th} order (n is a natural number) polynomial function.

All components constituting the embodiments have been described above as being coupled as one or operated by being coupled, but are not necessarily limited to these embodiments, and within the scope of the purpose, one or more of all components may be operated by being selectively coupled. In addition, the terms such as "comprise," "constitute," or "have" described above mean that the corresponding component may be inherent unless otherwise stated, and thus should be construed as further including another component rather than excluding another component.

The above description is merely the exemplary description of the technical spirit disclosed herein, and those skilled in the art to which embodiments disclosed herein pertain will be able to variously modify and change the embodiments without departing from the essential characteristics of the embodiments disclosed herein.

Therefore, the embodiments disclosed herein are not intended to limit the technical spirit disclosed herein, but for describing it, and the scope of the technical spirit disclosed herein is not limited by these embodiments. The scope of the technical spirit disclosed herein should be construed by the appended claims, and all technical spirits within the equivalent range should be construed as being included in the scope of this document.

[DESCRIPTION OF DRAWING SYMBOLS]
100: battery pack
110, 120, 130, 140: battery module
200: SOH prediction device
210: EIS data acquisition unit
220: feature point identification unit
230: resistance parameter calculation unit
240: SOH prediction unit
250: memory

## Claims

1. A state of health (SOH) prediction device comprising:
a battery pack;
an electrochemical impedance spectroscopy (EIS) data acquisition unit configured to acquire EIS data of the battery pack;
a feature point identification unit configured to identify a plurality of feature points based on the EIS data;
a resistance parameter calculation unit configured to calculate a resistance parameter related to impedance of the battery pack based on impedance related to the plurality of feature points; and
an SOH prediction unit configured to predict an SOH of the battery pack corresponding to the resistance parameter based on the resistance parameter corresponding to each of the plurality of temperatures and a first function representing tendency between the resistance parameter and the SOH of the battery pack.

2. The SOH prediction device of claim 1, wherein the EIS data includes data on an EIS graph shown by dividing the impedance of the battery pack into a real part and an imaginary part, and
a first feature point among the plurality of feature points is determined based on a size of the real part of the impedance among the plurality of points identified based on the EIS graph.

3. The SOH prediction device of claim 2, wherein the first feature point is related to a point at which a real part value of the impedance is the smallest among the plurality of points identified based on the EIS graph, or a point located within a preset range from the point at which the real part value is the smallest.

4. The SOH prediction device of claim 3, wherein the second feature point among the plurality of feature points is related to a maximum point of the EIS graph among the plurality of points identified based on the EIS graph, or a point located within a preset range from the maximum point.

5. The SOH prediction device of claim 4, wherein the maximum point is related to a point at which an absolute value is the greatest among points at which an imaginary part impedance value is negative among points having a higher frequency than points at which Warburg impedance is present among the plurality of points identified based on the EIS graph, or a point located within a preset range from the point at which the absolute value is the greatest among the points at which the value of the imaginary part impedance is negative.

6. The SOH prediction device of claim 4, wherein the resistance parameter calculation unit calculates the resistance parameter based on a difference between the real part value of the impedance related to the second feature point and the real part value of the impedance related to the first feature point.

7. The SOH prediction device of claim 6, wherein the first function is generated based on a plurality of SOHs included in a reference SOH in a preset SOC condition and a preset temperature condition of the reference battery pack in the idle state, and a resistance parameter corresponding to each of the plurality of SOHs.

8. The SOH prediction device of claim 7, wherein the first function includes at least one of an n^{th} order (n is a natural number) polynomial function, an exponential function, and a logarithmic function.

9. A method of operating a state of health (SOH) prediction device, the method comprising:
acquiring electrochemical impedance spectroscopy (EIS) data of a battery pack;
identifying a plurality of feature points based on the EIS data;
calculating a resistance parameter related to impedance of the battery pack based on impedance related to the plurality of feature points; and
predicting an SOH of the battery pack corresponding to the calculated resistance parameter based on the resistance parameter corresponding to each of the plurality of temperatures and a first function representing tendency between the resistance parameter and the SOH of the battery pack.

10. The method of claim 9, wherein the EIS data includes data on an EIS graph shown by dividing the impedance of the battery pack into a real part and an imaginary part, and
a first feature point among the plurality of feature points is determined based on a size of the real part of the impedance among the plurality of points identified based on the EIS graph.

11. The method of claim 10, wherein the first feature point is related to a point at which a real part value of the impedance is the smallest among the plurality of points identified based on the EIS graph, or a point located within a preset range from the point at which the real part value is the smallest, and
the second feature point is related to a maximum point of the EIS graph among the plurality of points identified based on the EIS graph, or a point located within a preset range from the maximum point.

12. The method of claim 9, wherein the first function is generated based on a plurality of SOHs included in a reference SOH in a preset SOC condition and a preset temperature condition of the reference battery pack in the idle state, and a resistance parameter corresponding to each of the plurality of SOHs.

13. The method of claim 12, wherein the first function includes at least one of an n^{th} order (n is a natural number) polynomial function, an exponential function, and a logarithmic function.
